# EUROPEAN PATENT APPLICATION

(11) **EP 0 892 440 A1**
(43) Date of publication of application: **20.01.1999**
(21) Application number: 97305399.4
(22) Date of filing: 18.07.1997
(51) Int. Cl.: H01L 29/78, H01L 29/786, H01L 27/092, H01L 27/108

(54) **Controllable conduction device**

(71) Applicant: HITACHI EUROPE LIMITED, Maidenhead, Berkshire, SL6 8YA (GB)
(72) Inventor: Nakazato, Kazuo, Cambridge, CB2 2RP (GB); Itoh, Kiyoo, Higashi-Kurume, Tokyo 203 (JP)
(74) Representative: Read, Matthew Charles

(57) **Abstract**

A transistor comprises source and drain regions 5, 2 between which extends a conduction path P for charge carriers, a gate 4 for controlling charge carrier flow along the conduction path and a multiple layer structure 3 providing a multiple tunnel junction configuration in the conduction path, the layers of the multiple layer structure 3 extending transversely of the conduction path, with the result that current leakage is blocked by the multiple tunnel junction configuration when the transistor is in its off state. Vertical and lateral transistor configurations are described, together with use of the transistor in complimentary pairs and for a random access memory cell.

## Description

This invention relates to a controllable conduction device with improved, reduced leakage current characteristics.

Integrated circuits have become progressively more miniaturised since their invention in 1959. Initially, their performance was improved by reducing the size of transistors used in the circuits, because the size reduction produced a reduction in parasitic capacitances of the circuit and a reduction in power dissipation. The miniaturisation was achieved by linearly scaling down the size of the features of the integrated circuit, by miniaturising the scale of the lithographic masks used in the manufacturing process.

However, as the scale of the devices was reduced further, it was found that the electrical characteristics of the resulting circuit did not scale linearly, and as a result, the configuration of the individual transistors in the circuit needed to be modified in order to optimise performance.

For example, current leakage from individual transistors of the circuits becomes a prominent factor degrading device performance as the device is miniaturised further and in high capacity dynamic random access memory (DRAM) cells, complex, three dimensional capacitors have been proposed in order to compensate for leakage current. However, the fabrication of such capacitors becomes unduly complicated.

Recently an alternative approach has been demonstrated, applicable to integrated circuits, in which transport of individual groups of electrons, in theory single electrons, is controlled. Reference is directed to "Single-electron memory", K. Nakazato, R. J. Blaikie and H. Ahmed, J. Appl. Phys. 75, 5123 (1994). A single electron memory is disclosed in our WO94/15340. In this device, a small group of electrons e.g. less than ten electrons, is stored at a node, which consists of a island constructed on the nanometre scale by electron beam lithography. The charge that can exist at the node is limited by the so-called Coulomb blockade effect. Once charged with the small group of electrons, no additional electrons can enter the island, due to its charging energy. In order to demonstrate the Coulomb blockade effect, the charging energy of the island needs to exceed the surrounding thermal energy, so that thermal electrons do not swamp the charge of the island. This requires either the device to be cooled to liquid nitrogen temperatures to reduce the thermal energy or, if the device is to operate at room temperature, the scale of the island needs to be of the order of 1 or 2 nm, which is beyond the capability of current e-beam lithographic techniques.

Charge is caused to enter and leave the island by means of a multiple tunnel junction device. In the device disclosed in WO94/15340 *supra*, the multiple tunnel junction device comprises a side gated structure which gives rise to multiple, stable electron states on the island, which can be used to provide a memory.

It has previously been proposed to improve the characteristics of a conventional transistor, which operates using a conventional current, which comprises many thousands of electrons per second, by associating a multiple tunnel junction device with the gate of the transistor, so that when in the off state, the multiple tunnel junction device minimises leakage current. Reference is directed to our EP-A-0 649 174. In this device, the gate is provided with a finger structure, constructed on the nanometre scale so as to produce e.g. by a field effect, a series of tunnel barriers in the source-drain path of the transistor. The multiple barriers act as a multiple tunnel junction so that in the off state, electron transport through the device is limited by Coulomb blockade, thereby significantly reducing leakage current from the drain to the source. However, this device is difficult to manufacture because the finger members formed in the gate need to be fabricated on a nanometre scale and current technologies do not permit such a device to be constructed readily on a scale small enough for operation at room temperature.
The present invention provides an alternative approach. According to the invention, a controllable conduction device is provided, comprising source and drain regions, a conduction path for charge carriers between the source and drain regions, a gate for controlling charge carrier flow along the conduction path, and a multiple layer structure providing a multiple tunnel junction configuration in the conduction path, wherein the conduction path extends transversely through the layers of the multiple layer structure.

The multiple tunnel junction configuration may comprise a plurality of alternating layers of relatively conductive and non-conductive material. For example, alternating layers of silicon and silicon nitride can be wed, although an oxide of silicon can be wed instead of the nitride layer.

The alternating layers of non-conductive material may have a thickness of 3nm or less, so as to provide the tunnel barrier configuration.

In use, a conventional current may flow along the conduction path between the source and drain regions, which can be switched between on and off states by applying a voltage to the gate. When in the off state, the leakage current is extremely small due to the barrier configurations presented by the multiple tunnel junction configuration in the source-drain conduction path. The layers can be made of sufficiently small thickness that the tunnel junction device blocks charge leakage at room temperature.

The device may be constructed on a substrate, with the alternating layers of the multiple tunnel junction being formed on the substrate. The substrate is conveniently an insulating layer and, where the device is made of silicon containing layers, an insulating silicon dioxide layer on a silicon wafer substrate may be used. However, other insulating substrates may be used, for example quartz, where it is desired to incorporate an array of conduction devices according to the invention in a display. Other substrates may be wed such as ceramics or metals.

Thus, by means of the invention, controllable conduction devices operable with a conventional current may be further miniaturised, whilst suffering less from the problem of leakage current than hitherto.

Complementary structures may be formed, including first and second of the devices, of different conductivity types, which may be stacked one upon the other.

A device according to the invention may be used in a memory cell including a charge storage capacitor, for selectively writing charge to the capacitor. An array of the memory cells may be provided.

The invention also includes a method of fabricating a controllable conduction device comprising: forming a multiple layer structure to provide a multiple tunnel junction configuration, and forming source and drain regions for a conduction path for charge carriers, and a gate for controlling charge carrier flow along the conduction path, such that the path extends transversely through the layers of the multiple layer structure.

The source and drain regions may be formed in an overlying relationship. This may be achieved by forming a first conductive doped layer on a substrate, forming the multiple layer structure to overlie the first conductive doped layer, forming a second doped conductive layer to overlie the multiple layer structure, and configuring the first and second doped layers into the source and drain regions.

Alternatively, the source and drain regions may be formed in a laterally spaced relationship.

In order that the invention may be more fully understood embodiments thereof will now be described by way of example with reference to the accompanying drawings in which:
Figure 1 is a schematic cross sectional view of a vertical transistor structure in accordance with the invention;
Figures 2a and 2b are energy diagrams for explaining the operation of the tunnel barrier configuration shown in Figure 1 in the absence of a source-drain voltage and, when forward biassed by a source-drain voltage respectively;
Figures 3a-l illustrate process steps in the fabrication of a vertical transistor structure in accordance with the invention;
Figure 4 illustrates schematically in plan view the device manufactured by the process shown in Figure 3;
Figure 5 is a graph illustrating the operating characteristics of the device;
Figure 6 is a schematic sectional view of a lateral transistor device in accordance with the invention;
Figures 7a-j illustrate process steps in the fabrication of a lateral transistor device in accordance with the invention;
Figure 8 is a schematic plan view of the device fabricated by the process of Figure 7;
Figure 9 is a schematic circuit diagram of a complimentary transistor pair;
Figure 10 is a schematic sectional view of the complimentary pair, fabricated with vertical transistors in accordance with the invention;
Figure 11 is a schematic plan view of the arrangement shown in Figure 10;
Figure 12 is a schematic circuit diagram of a random access memory cell;
Figure 13 is a schematic sectional view of the memory cell of Figure 12 when fabricated wing a vertical transistor structure in accordance with the invention; and
Figure 14 illustrates in section an alternative embodiment of the random access memory cell fabricated in accordance with the invention.

### First embodiment - Vertical Structure

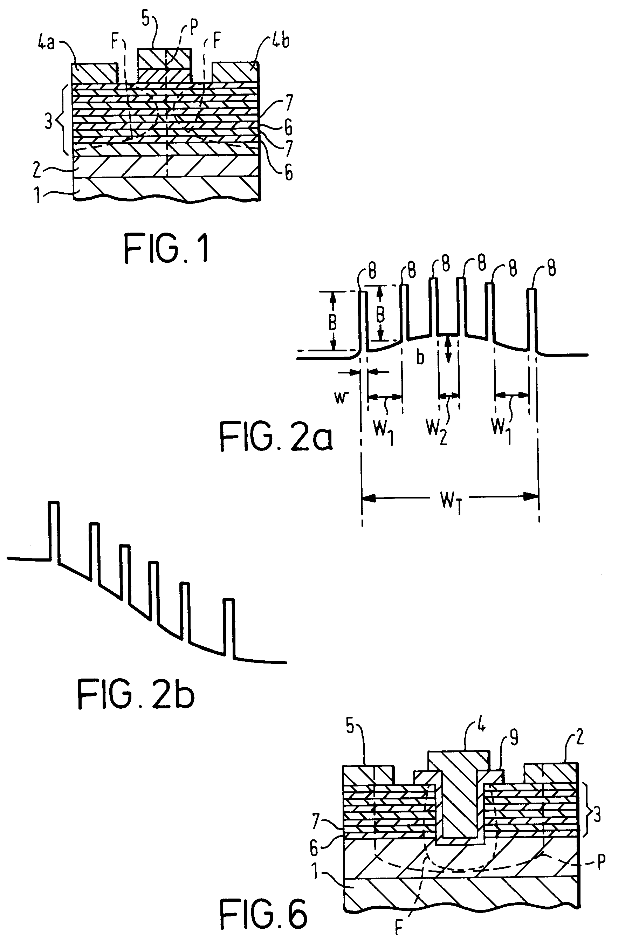

Figure 1 illustrates in section a first embodiment of controllable conduction device in accordance with the invention. The device comprises a substrate 1, with a drain region 2 comprising a layer of n-doped polysilicon, overlaid by a multiple layer structure 3 that gives rise to a multiple tunnel junction configuration. The layer structure 3 comprises alternate layers of relatively conducting and non-conducting material and in this example comprises layers of silicon and silicon nitride as will be explained in more detail herein. The multiple layer structure 3 is overlaid by gate regions 4a, 4b and source region 5 is disposed between the gate regions. The source and gate regions 4, 5 may comprise n-doped polysilicon. In use, current flows along a path P, from the drain 2 to the source 5, transversely of the planes of the layers in the structure 3. A voltage applied to the gate 4a, b controls the drain-source current. Equipotential field lines F produced by the gate voltage in the layer structure 3 are shown in dotted outline.

Referring to the multiple layer structure 3, it comprises silicon layers 6 disposed between layers 7 of electrically insulating, silicon nitride material. The insulating layers 7 are typically of the order of 3nm in thickness and give rise to an energy band diagram as shown in Figure 2a. The insulating layers 7 give rise to relatively high barriers 8, of height *B*, of a relatively narrow width dimension *w* corresponding to the width of the individual layers 7. In this example, the width dimension *w* is of the order of 3nm.

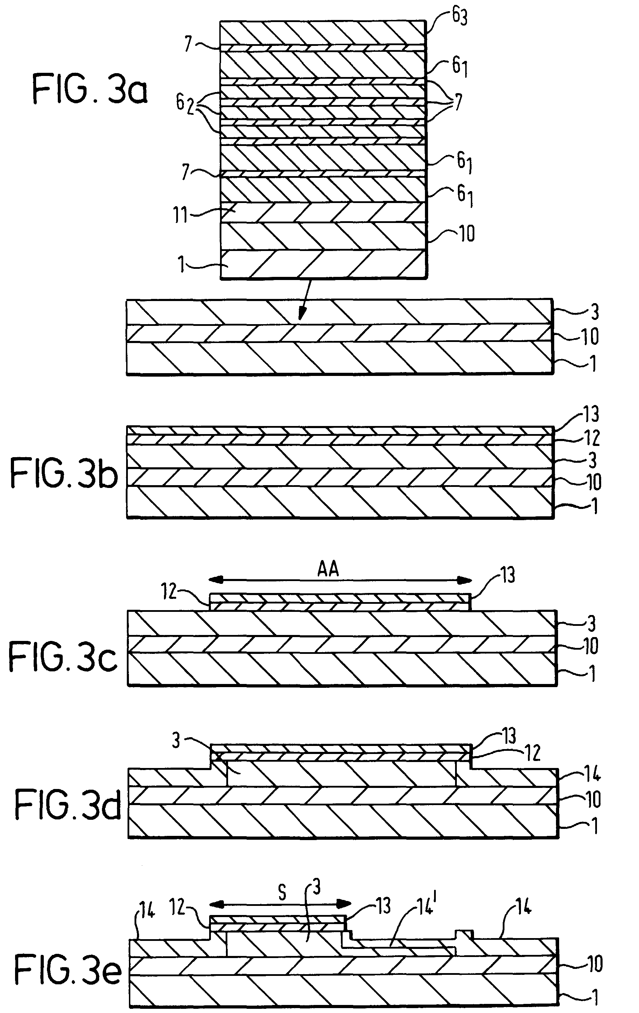

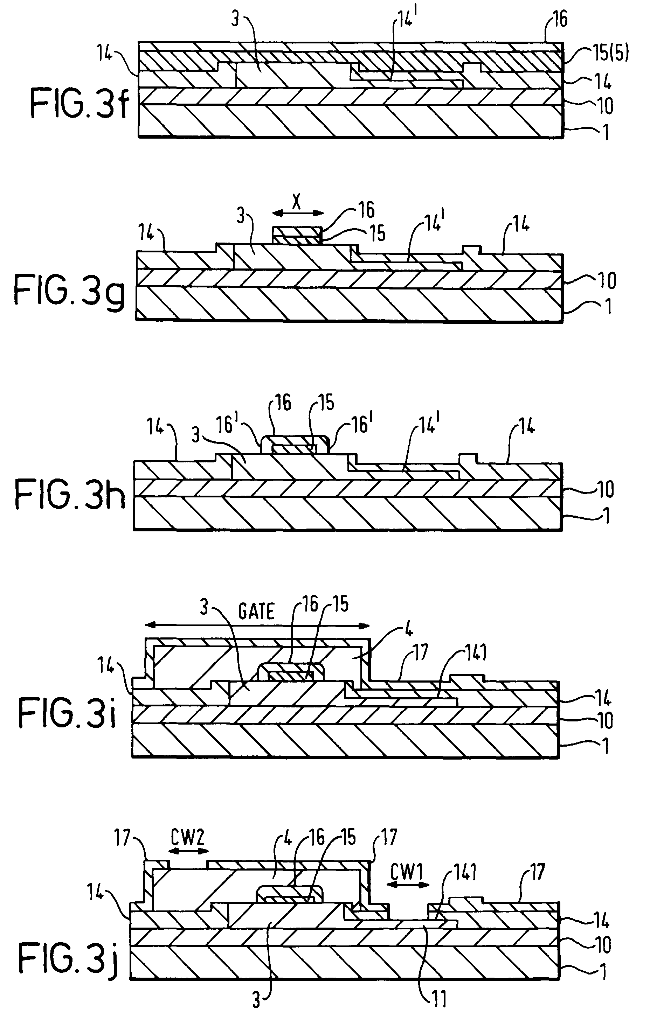

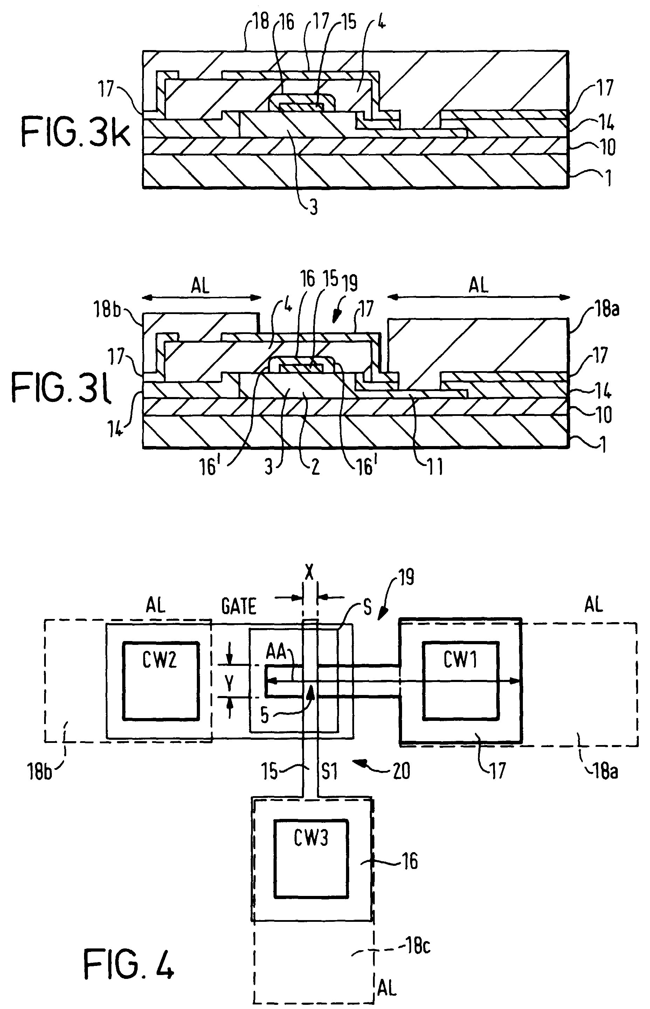

The spacing of the individual barriers 8 is determined by the thicknesses of the layers 6 of the conductive silicon material. Towards the top and bottom of the layer structure 3, the layers 6₁ (shown in detail in Figure 3a) have a thickness *W1* of the order of 50nm and in the central region of the stack, the layers 6₂ have a thickness *W2* of the order of 5nm.

Collectively, the layers of the structure 3 give rise to a barrier of height *b* which is relatively low compared to the barrier height *B* of the individual layers 7, but which is relative wide in terms of its physical dimension, corresponding to a width *W*_{*T*} of the entire multiple layer structure 3.

When a source-drain voltage is applied to the device, the energy diagram for the multiple layer structure 3 adopts the configuration shown in Figure 2b. It will be seen that electrons can pass from the source 5 to the drain 2, tunnelling through the relatively narrow barriers *w*, falling down the potential gradient provided by the source-drain voltage.

In the configuration shown in Figure 2a, when the source-drain voltage is zero, the relatively wide, but low barrier *b* presented by the layer structure 3 collectively, together with the relatively high barriers 8, of height *B*, gives rise to a barrier which inhibits charge carrier conduction between the source and drain 5, 2. The wide barrier *b* inhibits electron tunnelling between the source and drain and furthermore, the individual, spaced apart barriers 8 give rise to electron traps that inhibit electron tunnelling. The fact that the barriers at the top and bottom of the stack are spaced by a distance *W*_{*1*}, wider than the spacing *W*_{*2*} of the inner layers of the stack, contributes to increase the height *b* of the wide barrier. The barrier structure additionally inhibits leakage of current from the gate regions 4a, 4b, to the drain. It will be seen from Figure 1 that the multiple layer structure 3 presents a corresponding barrier to charge carrier conduction from the gate regions 4a, b, to the drain as for conduction from the source region 5.

When a source-drain voltage is applied, conduction occurs from the drain to the source in the manner of a conventional transistor and a conventional current flows, consisting of many thousands of electrons per second. Conduction along the path can be controlled by applying a gate voltage, in a conventional manner, which gives rise to a field which "pinches" the width of the conduction path P between the source and the drain, by an amount dependent on the gate voltage.

A method of fabricating the device will now be described in more detail with reference to Figure 3.

Referring to Figure 3a, the starting materials comprise a silicon wafer 1 which is thermally oxidised at 1000°C to form a 600 nm layer 10 of SiO₂, which acts as an insulating substrate. Then, a layer 11, which is wed to produce the drain 2 is formed on the SiO₂ layer 10. The layer 11 comprises 50 nm thickness polysilicon deposited in a reactor by low pressure chemical vapour deposition (LPCVD). A thin silicon dioxide layer of thickness of the order of 10nm is formed by thermal oxidisation on the surface of the layer 11. Arsenic ions are then implanted in the layer 11 to form an n±doped conductive layer that can be used for the drain 2. The arsenic ions are implanted with a dosage of 3 x 10¹⁵ cm⁻² at an energy of the order of 25 keV through the oxide layer (not shown). The oxide layer is then removed by wet etching using a 20:1 BHF solution.

Thereafter, a stack of the silicon and the silicon nitride layers 6, 7 are grown so as to form the multiple layer structure 3 that gives rise to the multiple tunnel junction. Initially, the layers 6 of silicon are formed to have a relatively large thickness W₁ = 50 nm and then, for the major part of the stack, the thickness of the layers 6₂ is of the order of W₂ = 5 nm. At least one further layer 6₁ of width W₁ is formed at the top of the stack and in this example, a further layer 6₃ of silicon is formed with a thickness of 30 nm.

The layers 6, 7 are formed in the LPCVD reactor. The process involves thermal nitridation of silicon as described in detail by M. Moslehi and K. C. Saraswat, IEEE Trans. Electron Device, ED-32, 106 (1985). so as to form thin, tunnel junctions, in which the thickness of the nitride is self-limited to around 2-3 nm, with a tunnel barrier height B of the order of 2eV.
The layer structure 3 is thus built up to form a superlattice by firstly depositing a silicon layer in the LPCVD reactor at 770°C in SiH₄ gas to achieve the appropriate thickness of silicon for the relevant layer shown in Figure 3a. Thereafter, the surface of the deposited silicon is directly converted to silicon nitride at 930°C for 20 minutes in a 100% NH₃ gaseous atmosphere at 1 Torr in the reactor. Then a further layer of silicon is deposited on the silicon nitride in the same chamber. Accordingly, pure silicon nitride without any silicon oxide is formed between the successive deposited silicon layers.

Referring to Figure 3b, a layer 12 of silicon dioxide of thickness 10 nm is formed by thermal oxidisation over the layer structure 3, and a silicon nitride layer 13 of thickness 160 nm is formed in the LPCVD reactor, at a temperature of 740°C.

Referring to Figure 3c, the layers 12, 13 are then patterned using optical lithography and a dry etching method in an atmosphere of CHF₃ and argon gas, in a manner well known *per se*. The resulting structure has a lateral width dimension AA and a breadth (described later with reference to Figure 4) of dimension Y.

As shown in Figure 3d, the patterned layers 12, 13 are then used as a mask in order to dry etch the multiple layer structure 3 so as to remove most of the layers 6, 7 outside of the dimension AA, but leaving a thickness of approximately 80 nm of the structure 3 outside of the masked pattern. This remaining portion of the region 3 is then converted into silicon dioxide by thermal oxidisation to form isolation regions 14 in order to isolate adjacent transistors (not shown) formed by the inventive method on the same substrate 1.

Referring to Figure 3e, the layers 12, 13 are patterned using optical lithography and a dry etching method in an atmosphere of CHF₃ and argon gas. The patterned layers 12, 13 are then used as a mask in order to dry etch the multiple layer structure 3 so as to remove most of the layers 6, 7 outside of the dimension S, but leaving a thickness of approximately 80 nm of the structure 3 outside the masked pattern. The remaining portion of the region 3 is thermally oxidised to form silicon oxide isolation layer 14 of thickness 50 nm.

Referring to Figure 3f, the silicon nitride and silicon oxide layers 12, 13 are removed using orthophosphoric acid at 160°C and a 20:1 BHF solution. Then, a layer 15 of polysilicon is deposited with a thickness of 100 nm by LPCVD. A silicon oxide layer 16 of thickness 100 nm is then deposited on the layer 15. Arsenic ions are implanted at an energy of 140 kev and a dosage of 5 x 10¹⁵ cm⁻² in order to change the silicon layer 15 to a heavily doped, n-type layer. Thermal annealing at 800°C for one minute is then carried out in order to activate the arsenic ions and provide heavily n-doped electrical characteristics in the layer 15, which is used later to provide the source 5 of the device.

Referring to Figure 3g, the silicon dioxide layer 16 is patterned using electron beam lithography and dry etching to provide an elongate region of width X which will be used as a mask to define the source region 5. Then the silicon layer 15 is correspondingly etched in CF₄ gas, down almost to the layer structure 3. Referring to Figure 3h, an insulating SiO₂ layer is deposited and then etched in CHF₃ and argon gas, so as to leave side wall SiO₂ regions 16.

Referring to Figure 3i, a layer 4 of polysilicon for forming the gate is deposited to a thickness of 100 nm by LPCVD. Using optical lithography and dry etching, the polysilicon layer is removed outside of the dimension "GATE". An insulating SiO₂ layer 17 is then deposited to a thickness 100 nm by CVD.

Then, as shown in Figure 3j, a contact window CW1 is etched through the oxide layers 17 and 14' in order to allow electrical connection to be made to the layer 11 - the lowermost layer of the multiple layer structure 3, which forms the drain 2. The contact window CW1 is formed by optical lithography and wet etching wing 20:1 BHF solution. At the same time, a contact window CW2 is made to the gate.

As shown in Figure 3k, a metallisation layer 18 is formed by sputtering in order to provide electrical connections to the gate and the drain. The layer 18 comprises an initial layer of titanium, of 100 nm thickness, overlaid by a 1000 nm thickness layer of aluminium/silicon (1%), produced by conventional sputtering techniques.

As shown in Figure 3l, an electrical insulation space 19 is etched into the layer 18 so as to provide first and second portions 18a, 18b. The portion 18a provides a connection through the contact window CW1 to the layer 11, and hence to the drain region 2. The portion 18b provides a connection through window CW2 to the layer 4, which overlies the insulating layers 16, around the multiple layer structure 3, that gives rise to the multiple tunnel junction device, and thus acts as a gate.

The resulting device is shown schematically in plan view in Figure 4. From Figure 4 it can be seen that the process step described with reference to Figure 3j that formed the contact window CW1 and CW2 can also be used to form a contact window CW3 through the SiO₂ overlayer 16, so as to provide an external electrical connection to the heavily doped n-type region 15 that forms the source region 5. Additionally, when the insulating gap 19 (Figure 3l) is formed, an insulating gap 20 (Figure 4) is also formed so as to define portion 18c of the sputtered layer 18. This provides an electrical connection through contact window CW2 to the source 5 through conductive layer 15.

During and after the growth of the layers 6, 7 of the multi-layer structure 3, the overall wafer is heated to 900-1000°C for several hours in to form the isolation regions 14, 14' by thermal oxidisation. However, to ensure that the resulting device operates successfully, it is important that the dopants from the heavily doped source and drain regions 5, 2 do not migrate into the silicon layers 6₁ of the layer structure 3. In the described embodiment, the uppermost and lowermost layers 7 of silicon nitride act as barriers fro the n+ dopants in the layers 10, 15 and prevent them from diffusing into the central region of the multi-layer structure 3 during the heating process.

Figure 4 shows the active region of the transistor to be X x Y. Typically X = 50 nm and Y = 200 nm.

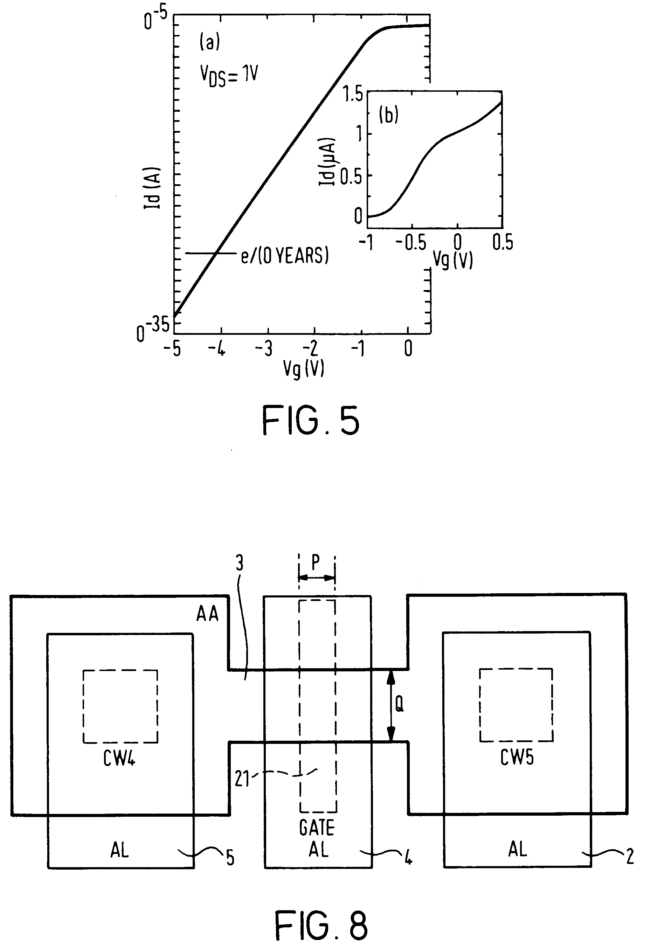

Figure 5 illustrates the electrical characteristics of the resulting vertical transistor. The transistor exhibits an extremely low leakage current when switched off. Typically, the transistor is switched to its off state when a negative gate voltage is applied, thereby switching off conduction between the source and the drain 2, 5. The escape time of one electron was estimated to be of the order of 10 years at a gate voltage of -4v at normal room temperature. The current I_{DS} in the on state is small compared with a conventional transistor, of the order of 1µA, due to the resistance of the multiple tunnel junction configuration 3. A high switching speed can be obtained, by reducing the number of electrons that flow along the conductive path. This is achieved by making the dimensions X x Y small as compared with conventional transistors, as can be seen by the example given hereinabove, with the advantage that the size of the device can be reduced significantly, compared with prior art transistors. Thus, with a device constructed as described herein, the charging/discharging time, Q/I_{DS} is around 1 n sec when Q = 6000e (where e represents the charge of 1 electron). If higher currents are required, transistors can be connected in parallel.

### Second embodiment - Lateral Structure

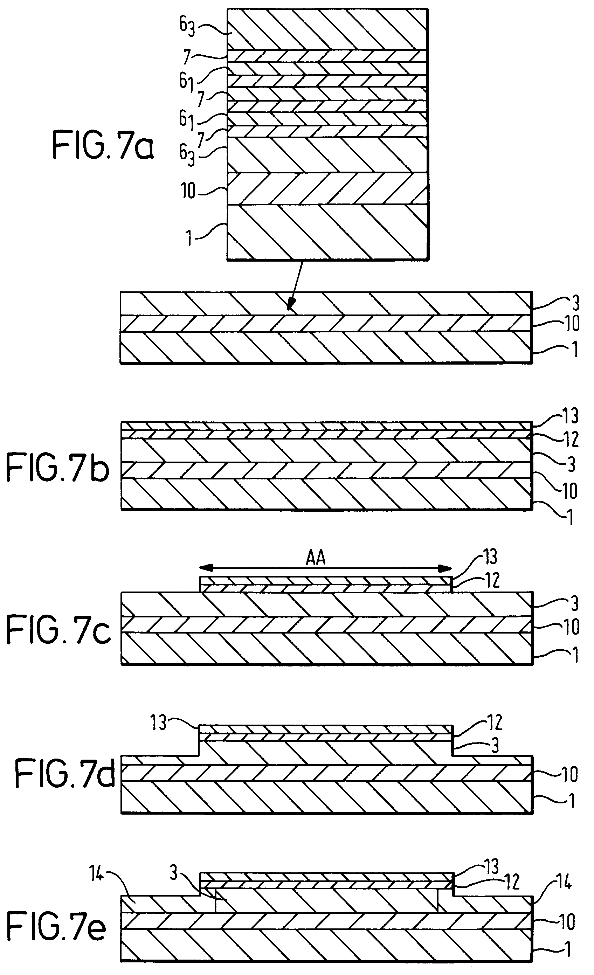

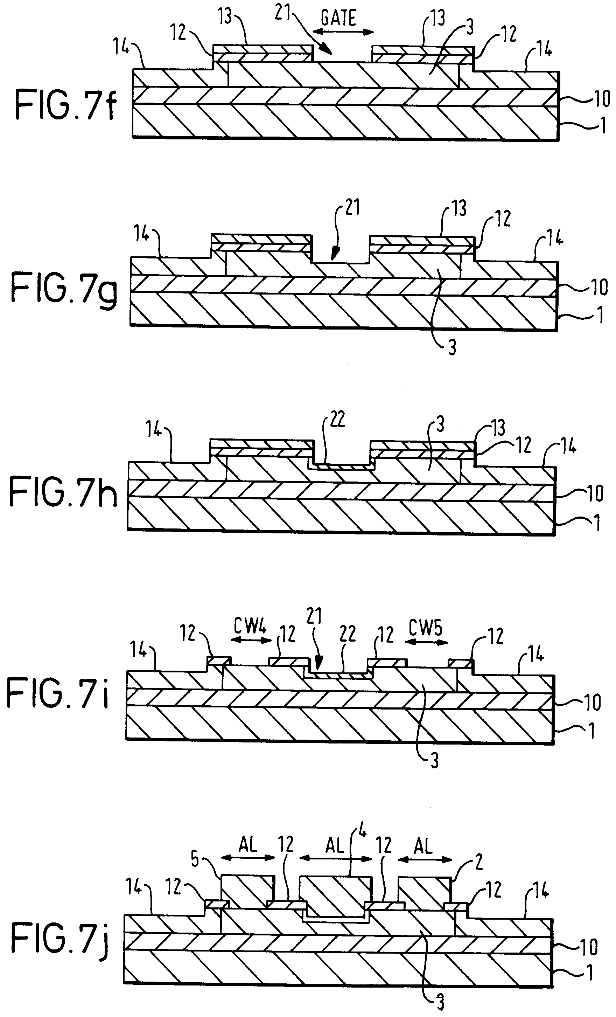

A lateral transistor structure in accordance with the invention is shown in cross section schematically in Figure 6. Like parts of the device to those shown in Figure 1 are marked with the same reference numbers. In this embodiment, the source and drain regions 2, 5 are disposed laterally spaced apart, with the gate 4 between them. The source and drain regions 2, 5 both overlie the multiple layer structure 3 and the gate 4 extends into the structure 3, surrounded by an insulating layer 9. The conduction path P between the source and drain 5, 2 is shown schematically in dotted outline, and extends downwardly through the structure 3, transversely of the layers thereof, around the gate 4 and then vertically upwardly through the layer structure 3, transversely of its layers, to the drain 2. As shown by the equipotential field line F, a voltage applied to the gate 4 controls conduction between the source and the drain. The resulting lateral structure is characterised by a low leakage current in a similar way to the vertical structure previously described. A practical example of a fabrication method for the lateral device of Figure 6, will now be described in detail with reference to Figure 7. The process uses similar techniques to those described in relation to Figure 3. In Figure 7a, the initial silicon wafer 1 is thermally oxidised at 1000°C to form a 600 nm thickness layer 10 of silicon dioxide. Then, the multiple layer structure 3 is formed generally in the manner previously described in relation to Figure 3, but with the drain layer 11 omitted.

A first layer 6₃ of polysilicon is grown onto the layer 10 followed by a sequence of layers 7 of silicon nitride, and 6₁ of polysilicon, of thicknesses 3nm and 5nm respectively, in a manner previously described with reference to Figure 3a. A further polysilicon layer 6₃ of thickness 100 nm is grown on the top of the sequence.

Referring to Figure 7b, a silicon dioxide layer 12 of thickness 100 nm is formed by thermal oxidisation and is then subjected to ion implantation with arsenic ions with a dosage of 5 x 10¹⁵ cm⁻², at an energy level of 140 keV. Thermal annealing is then carried out at 800°C for one minute in order to activate the arsenic ions. Then, a layer 13 of silicon nitride, of thickness 160 nm is deposited over the layer 12 at a temperature 740°C.

As shown in Figure 7c, the layer structure 12, 13 is subjected to optical lithography and dry etching using CHF₃ and argon gases in order to form a pattern of width AA. As shown in Figure 7d, the pattern is then dry etched into the layers of the multiple layer structure 3, leaving a thickness of approximately 80 nm in the etched areas, in a similar way to the method described previously with reference to Figure 3d.

Then, as shown in Figure 7e, silicon dioxide isolation regions are formed around the remaining part of the multiple layer structure 3.

Figure 7f illustrates how an opening 21 is formed in the layers 12, 13, to receive the gate 4. The opening 21 is etched in the layers 12, 13 by conventional optical lithography and dry etching, in an atmosphere of CHF₃ and argon gases. The multiple layer structure 3 is then dry etched through the gate opening 21 using CF₄ gas until the etched part has a thickness of the order of 80 nm, as shown in Figure 7g.

Then, as shown in Figure 7h, silicon dioxide in a layer 22 is grown in the gate opening 21, to a thickness of 20 nm by conventional thermal oxidation.

As shown in Figure 7i, the silicon nitride layer 13 is then removed by the use of orthophosphoric acid at a temperature of 160°C. Then, using optical lithography and wet etching with a 20:1 BHF solution, the remaining silicon oxide layer 12 is patterned to provide contact windows CW4, CW5 for the source and drain 5, 2 respectively.

As shown in Figure 7j, electrodes for the source, drain and gate regions 5, 2, 4 are sputtered into the opening CW4, CW5 and 21. The sputtered metallisation consists of 100 nm thickness titanium followed by 1000 nm thickness aluminium/silicon (1%). The metallisation is applied as a continuous layer and then using optical lithography and wet etching is patterned to provide the respective drain, gate and source regions 2, 4 and 5 shown in Figure 5j.

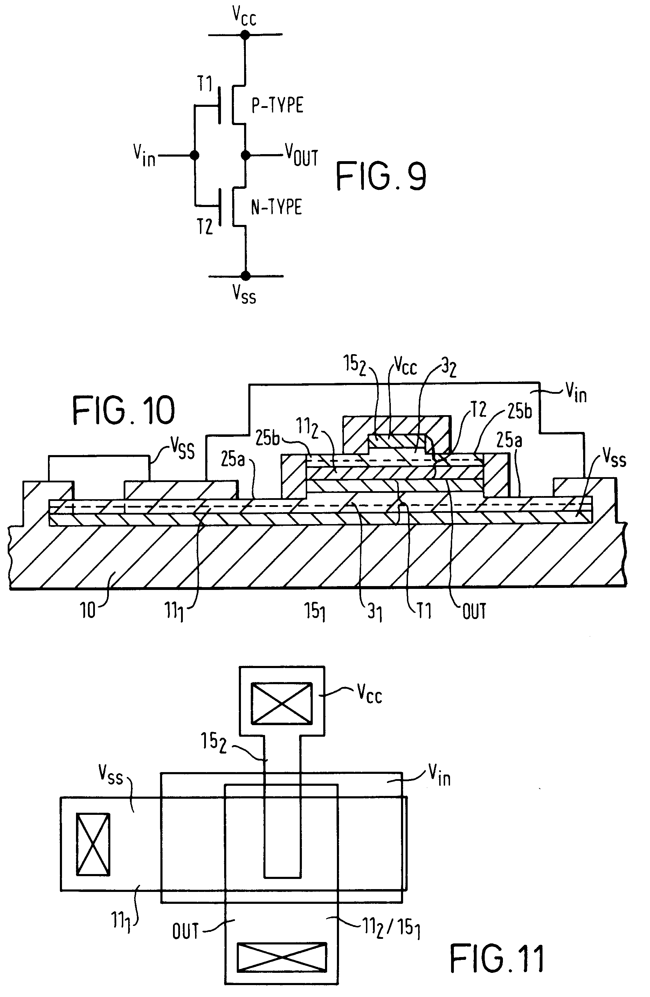

Figure 8 illustrates the resulting lateral transistor in plan view. The area of the gate region is given by P x Q. In a typical example, P = 150 nm and Q = 200 nm.

It will be understood that large arrays of transistors according to the invention may be formed on a single substrate and they may be of vertical or lateral structures as described previously or a mixture of both. The substrate need not necessarily be silicon and the transistors can be formed on a substrate such as quartz or metal for use, for example in a flat display. The extremely low leakage current results in a very low power consumption. The described transistors in accordance with the invention can be configured to have complimentary conduction characteristics. An n-type transistor can be produced by doping the source and drain regions with n-type impurities such as arsenic or phosphorous, and p-type device is produced when the source and drain regions are doped with p-type impurities such as boron. The resulting transistors can be stacked in complimentary pairs and an example will now be described with reference to Figures 9, 10 and 11. The circuit diagram of the complimentary pair is shown in Figure 9 and comprises complimentary n and p-type transistors T1 and T2, with a common gate connection Vᵢₙ. The source-drain paths of the transistors are connected in series between rails V_{cc} and Vₛₛ, with a common output connection Vₒᵤₜ.

Referring to Figure 10, the transistor T2 is shown stacked on transistor T1, which itself is formed on a substrate layer 10 which may comprise silicon dioxide as described previously.

The transistor T1 comprises a multiple layer structure 3₁ sandwiched between n ⁺ polysilicon layers 11₁ 15₁, so as to form an n-doped vertical structure similar to that described with reference to Figure 3.

The p-type transistor T2 consists of a multiple layer structure 3₂ corresponding to the structure 3 shown in Figure 3, sandwiched between p ⁺ doped polysilicon layers 11₂ and 15₂. A common gate region 25, which may comprise a spluttered metallic layer 18 described previously with reference to Figure 3k, is applied over both of the transistors T1, T2. The voltage Vᵢₙ applied to the common gate region 25 controls charge carrier flow in a conduction path transversely through the layers of the multiple layer structure 3₁, by virtue of an electrical field applied through regions 25a into the multiple layer structure 3₁. A corresponding current control is achieved in the layer structure 3₂ for transistor T2, as a result of the field applied from the gate through regions 25b. Since the transistors are stacked upon one another, the complimentary pair of transistors only takes up the area of a single transistor on the substrate.

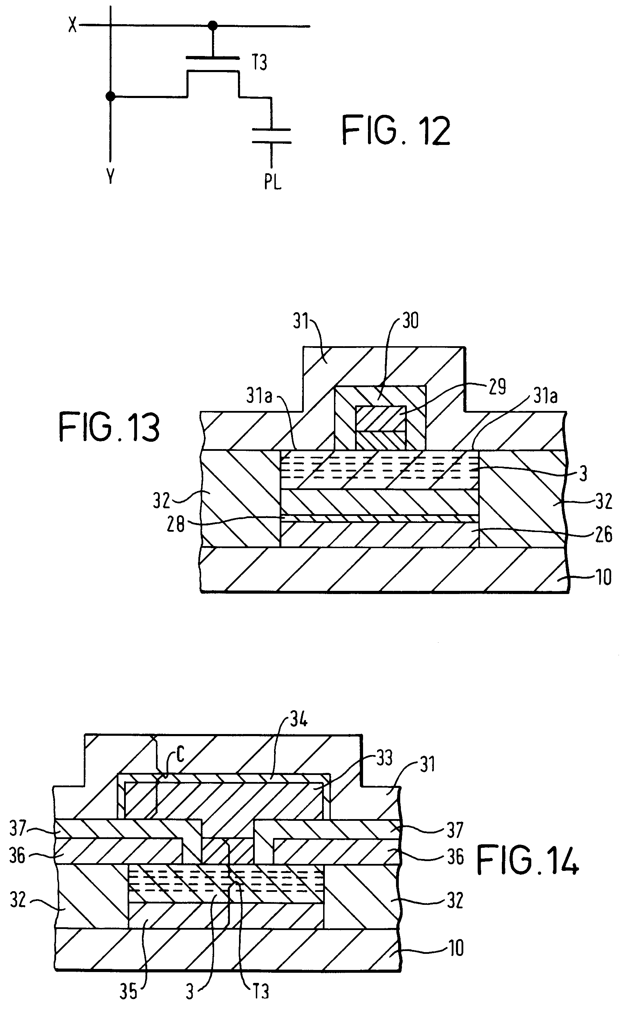

The previously described vertical transistor structure according to the invention can also be used with advantage to form memory cells in a memory cell array, for example in a random access memory. The conventional circuit diagram for a random access memory cell is shown in Figure 12 and consists of a row line X and a column line Y coupled through a transistor T3 to a storage capacitor C. In the usual way, charge can be written to, or erased from the storage capacitor C by selectively switching on or off the transistor T3 by means of row and column voltages applied to the lines X, Y.

Figure 13 illustrates a first embodiment of memory cell, corresponding to the circuit of Figure 12, formed so as to include a vertical transistor structure in accordance with the invention. The device consists of a silicon dioxide layer 10 formed on a substrate 1 (not shown) in the manner previously described. The capacitor C consists of first and second electrode plates 26, 27 formed of layers of n⁺ doped polysilicon of thickness 50nm A dielectric layer 28 is sandwiched between the electrode plates 26, 27. The dielectric layer consists of a 5 nm thick layer of silicon dioxide in this example. The layer 27 of the capacitor also acts as the drain for a vertical transistor structure that includes a source 29 formed of a layer of n⁺ doped polysilicon of thickness 50nm and a multiple layer 3, fabricated as previously described to include alternate layers of silicon and silicon nitride to form a multiple tunnel junction configuration. The source layer 29 is covered by an insulating silicon dioxide layer 30. The row line X is formed by a layer of n⁺ doped polysilicon 31, which runs transversely of the Y line 29. The layer 31 acts as a gate for the transistor and applies a field for controlling the conduction path through the layer structure 3 in regions 31a, in the manner described with reference to Figure 1.

Thus, by applying a combination of voltages to the X and Y lines 29, 31, charge can be selectively written to and erased from the capacitor defined by the layers 26, 27 and 28. Regions of insulating silicon dioxide 32 surround the capacitor C and transistor T3 to enable elements of a two dimensional array to be constructed, without significant charge leakage between the elements.

Another embodiment of the memory cell array is shown in Figure 14. In this embodiment, the capacitor C overlies the transistor T3. The capacitor C comprises an n+ polysilicon layer 31, which acts as a reference potential for the capacitor and a n+ polysilicon layer 33, which each act as a plate of the capacitor, and a dielectric layer 34, between the plates, comprising a 5 nm thickness insulating layer 34, formed of silicon dioxide.

The transistor T3 in this embodiment comprises a n+ polysilicon layer 35 which also runs over the chip to act as the Y column line, above which is formed the multiple layer structure 3, formed as previously described. The plate 33 of the capacitor C acts as the source for the transistor T3. The row line X is formed of a n⁺ doped polysilicon layer 36, insulated from the layer 31 and the capacitor by a silicon dioxide layer 37. A voltage applied to the X line 36 acts in region 36a to control the conduction that occurs in transistor T3, transversely through the layers of the multiple layer structure 3, so as to control the transfer of charge to and from the capacitor C. Insulating silicon dioxide layers 32 isolate the memory cell from adjacent cells in the array.

Since the transistor T3 in the described embodiments of memory cell has an extremely low leakage current when in the off state, the power consumption of the memory cell is extremely low and as a result, the refreshment duty cycle can be decreased as compared with prior art devices.

Many modifications and variations to the described examples, falling within the scope of the invention, will be apparent to those skilled in the art. For example, whilst silicon nitride has been used in the layer structure 3 to provide tunnel barriers, it will be appreciated that other insulating films such as silicon dioxide could be used.

## Claims

1. A controllable conduction device comprising: source and drain regions, a conduction path for charge carriers between the source and drain regions, a gate for controlling charge carrier flow along the conduction path, and a multiple layer structure providing a multiple tunnel junction configuration in the conduction path, the conduction path extending transversely through the layers of the multiple layer structure.

2. A device according to claim 1 wherein the multiple tunnel junction configuration comprises a plurality of alternating layers of relatively conductive and non conductive material.

3. A device according to claim 2 wherein the alternating layers contain silicon.

4. A device according to claim 3 comprising alternating layers of silicon and silicon nitride.

5. A device according to claim 3 comprising alternating layers of silicon and an oxide of silicon.

6. A device according to any preceding claim wherein the layers have a thickness of 5 nm or less.

7. A device according to claim 2 wherein the non conductive layers have a thickness of 3 nm or less.

8. A device according to any preceding claim wherein at least one of the source and drain regions overlies the layer configuration.

9. A device according to claim 8 wherein the other of the regions underlies the multiple layer configuration.

10. A device according to claim 8 wherein both of the source and drain regions overlie the multiple layer configuration.

11. A device according to claim 10 wherein the gate extends into the multiple layer structure between the source and drain regions.

12. A device according to any preceding claim including a substrate on which the layers of the multiple tunnel junction configuration are formed.

13. A device according to claim 12 wherein the substrate is formed of an electrically insulating material.

14. A device according to claim 13 wherein the substrate is formed of a quartz or a ceramic material.

15. A device according to claim 12 wherein the substrate is formed of a metal.

16. A device according to claim 12 wherein the substrate is formed of silicon with a layer of oxide thereon.

17. A transistor structure including a first and a second device each according to any preceding claim and of different conductivity types.

18. A structure according to claim 17 wherein the devices are stacked one upon the other.

19. A memory cell including a charge storage capacitor and a device according to any one of claims 1 to 17 for selectively writing charge to the capacitor.

20. An array of memory cells according to claim 19.

21. A method of fabricating a controllable conduction device comprising: forming a multiple layer structure to provide a multiple tunnel junction configuration, and forming source and drain regions for a conduction path for charge carriers, and a gate for controlling charge carrier flow along the conduction path, such that the path extends transversely through the layers of the multiple layer structure.

22. A method according to claim 21 including forming the source and drain regions to be in an overlying relationship.

23. A method according to claim 21 or 22 including forming a first conductive doped layer on a substrate, forming the multiple layer structure to overlie the first conductive doped layer, forming a second doped conductive layer to overlie the multiple layer structure, and configuring the first and second doped layers into the source and drain regions.

24. A method according to claim 21 including forming the source and drain regions to be in a laterally spaced relationship.

25. A method according to any one of claims 21 to 24 including forming the multiple layer structure by modulation doping.

26. A controllable conduction device fabricated by a method according to any one of claims 21 to 25.
